(19) Europäisches Patentamt
European Patent Office
Office européen des brevets

(11) **EP 3 796 428 B1**

(12) **EUROPEAN PATENT SPECIFICATION**

(45) Date of publication and mention
of the grant of the patent:
**08.06.2022  Bulletin 2022/23**

(21) Application number: **19878789.7**

(22) Date of filing: **26.09.2019**

(51) International Patent Classification (IPC):
*C23C 16/40* (2006.01)          *C23C 16/455* (2006.01)
*H01M 4/04* (2006.01)          *H01M 4/131* (2010.01)
*H01M 4/133* (2010.01)        *H01M 4/1391* (2010.01)
*H01M 4/1393* (2010.01)      *H01M 4/36* (2006.01)
*H01M 4/38* (2006.01)          *H01M 4/48* (2010.01)
*H01M 4/587* (2010.01)        *H01M 4/62* (2006.01)
*H01M 10/0525* (2010.01)

(52) Cooperative Patent Classification (CPC):
**C23C 16/403; C23C 16/405; C23C 16/45525;
H01M 4/04; H01M 4/0404; H01M 4/0428;
H01M 4/133; H01M 4/134; H01M 4/1393;
H01M 4/1395; H01M 4/364; H01M 4/382;
H01M 4/483; H01M 4/587; H01M 4/62;**          (Cont.)

(86) International application number:
**PCT/KR2019/012542**

(87) International publication number:
**WO 2020/091234 (07.05.2020 Gazette 2020/19)**

(54) **NEGATIVE ELECTRODE FOR LITHIUM SECONDARY BATTERY, LITHIUM SECONDARY BATTERY COMPRISING SAME, AND MANUFACTURING METHOD THEREFOR**

NEGATIVE ELEKTRODE FÜR EINE LITHIUMSEKUNDÄRBATTERIE,
LITHIUMSEKUNDÄRBATTERIE DAMIT UND HERSTELLUNGSVERFAHREN DAFÜR

ÉLECTRODE NÉGATIVE POUR BATTERIE SECONDAIRE AU LITHIUM, BATTERIE SECONDAIRE
AU LITHIUM LA COMPRENANT ET SON PROCÉDÉ DE FABRICATION

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority:  **31.10.2018  KR 20180132011**

(43) Date of publication of application:
**24.03.2021  Bulletin 2021/12**

(73) Proprietor: **LG Energy Solution, Ltd.**
**Seoul 07335 (KR)**

(72) Inventors:
• **HONG, Yeon Suk**
  **Daejeon 34122 (KR)**
• **KIM, Ju Ri**
  **Daejeon 34122 (KR)**

(74) Representative: **Hoffmann Eitle**
**Patent- und Rechtsanwälte PartmbB**
**Arabellastraße 30**
**81925 München (DE)**

(56) References cited:
**JP-A- H08 208 776      JP-A- H10 208 776
KR-A- 20140 107 833    KR-A- 20150 020 114
KR-A- 20160 044 730    KR-A- 20160 104 707
KR-A- 20160 137 220    KR-A- 20170 033 123
US-A1- 2017 104 192    US-A1- 2018 090 802**

(52) Cooperative Patent Classification (CPC): (Cont.)
**H01M 10/052; H01M 10/058;** H01M 4/131;
H01M 4/1391; H01M 4/625; H01M 2004/021;
H01M 2004/027; Y02E 60/10; Y02P 70/50

**Description**

[Technical Field]

This application claims the benefit of priority based on Korean Patent Application No. 10-2018-0132011, filed on October 31, 2018.

[Background Art]

As the price of energy sources increases due to depletion of fossil fuels and the interest in environmental pollution increases, the demand for environmentally friendly alternative energy sources becomes an indispensable factor for future life. Especially, as technology development and demand for mobile devices are increasing, demand for secondary batteries as energy sources is rapidly increasing.

Typically, in terms of the shape of the battery, there is a high demand for a prismatic secondary battery and a pouch-type secondary battery that can be applied to products such as mobile phones with a small thickness. In terms of materials, there is a high demand for lithium secondary batteries such as lithium ion batteries and lithium ion polymer batteries having high energy density, discharge voltage, and output stability.

Generally, in order to prepare a secondary battery, first, a positive electrode and a negative electrode are formed by applying an electrode mixture containing an electrode active material to a surface of a current collector, then a separate is interposed therebetween to thereby make an electrode assembly, which is then mounted in a cylindrical or rectangular metal can or inside a pouch-type case of an aluminum laminate sheet, and a liquid electrolyte is injected or impregnated into the electrode assembly or a solid electrolyte is used to prepare a secondary battery.

In general, the negative electrode of a lithium secondary battery uses a carbon material such as graphite, but the theoretical capacity density of carbon is 372 mAh/g (833 mAh/cm$^3$). Therefore, in order to improve the energy density of the negative electrode, silicon (Si), tin (Sn), oxides and alloys thereof which are alloyed with lithium are considered as negative electrode materials. Among them, silicon-based materials have attracted attention due to their low cost and high capacity (4200 mAh/g).

In the carbon-based negative electrode active material, a solid electrolyte interface (SEI) layer is formed on the surface of the negative electrode active material during an initial charge/discharge process (activation process). As a result, an initial irreversible phenomenon is caused and the electrolyte capacity is depleted in the course of continuous charge/discharge, thereby reducing the battery capacity.

In addition, although the silicon-based material shows a high capacity, a problem arises in that the initial irreversible capacity is large. During charging and discharging of the lithium secondary battery, lithium discharged from the positive electrode is inserted into the negative electrode at the time of charging, and is discharged from the negative electrode at the time of discharging and returns to the positive electrode. In the case of the silicon negative electrode active material, a large amount of lithium inserted into the negative electrode does not return to the positive electrode at the time of initial charging and thus the initial irreversible capacity becomes large. When the initial irreversible capacity increases, there occurs a problem that the battery capacity and the cycle are rapidly reduced.

As one of methods for solving the problems related to the initial irreversibility, prelithiation technologies for pre-inserting lithium into the negative electrode have been attempted. Among them, the lithium direct contact method is a method of directly laminating thin film lithium on the negative electrode layer, and after the cell assembly, the electrolyte is injected to move the lithium of the lithium layer to the negative electrode (diffusion) to increase the lithium content in the negative electrode, to thereby solve the problem of irreversible capacity reduction.

However, in the manufacture of a lithium secondary battery, it often happens that time is delayed when electrolyte is injected or until initial charge and discharge after cell assembly. Herein, before the injection of the electrolyte, lithium of the lithium layer attached to the negative electrode may be unevenly moved into the electrode (solid-diffusion), thereby increasing resistance, or lithium may be diffused into the air, causing a problem of loss of lithium amount.

On the other hand, Korean Patent Publication No. 10-2018-0057513 discloses a technology of interposing an anti-lithiation layer between an electrode layer and a lithium layer as an issue of fire or explosion is raised by occurrence of lithiation due to direct contact between the material of the electrode layer and the lithium layer in case of (pre) lithiation by the lithium direct contact method. The proposed technology is intended to prevent an accident such as a fire during the prelithiation process, but the technology does not recognize problems such as a lithium loss which occurs as the time until the electrolyte injection is delayed after laminating a lithium metal thin film on the negative electrode. Further, since the thickness of the anti-lithiation layer is 0.5 to 5$\mu$m, which is high, it causes a problem that deteriorates the battery performance by increasing the resistance. A similar solution is also disclosed in Japanese Patent Application JP H10 208776.

[Disclosure]

[Technical Problem]

An object of the present invention is to provide a novel (pre) lithiation method for a negative electrode for a lithium ion battery, a negative electrode prepared by the method and a lithium ion secondary battery including the negative electrode.

In addition, another object of the present invention is to minimize the amount of the lithium loss and to reduce the amount of lithium side reactions by relieving the solid-diffusion rate of lithium generated as the time until electrolyte injection is delayed after cell assembly.

In addition, another object of the present invention is to provide a method for (pre) lithiation of a negative electrode for a secondary battery having improved battery performance by improving a problem of a resistance increase of a lithium diffusion rate control layer.

[Technical Solution]

In order to solve the above problems, a negative electrode for a lithium secondary battery of the present invention includes a current collector; a negative electrode mixture layer formed on the current collector; a lithium diffusion rate control layer formed on the negative electrode mixture layer by atomic layer deposition; and a lithium layer formed on the lithium diffusion rate control layer.

In an example of the present invention, the lithium diffusion rate control layer may control diffusion of lithium from the lithium layer to the negative electrode mixture layer until injection of an electrolyte.

In an example of the present invention, the lithium diffusion rate control layer may control diffusion of lithium from the lithium layer to the negative electrode mixture layer until a first charge/discharge.

In the present invention, a thickness of the lithium diffusion rate control layer is 0.1 to 100 nm and preferably 0.5 to 50 nm.

In an example of the present invention, the negative electrode mixture layer may include one compound or a mixture of two or more selected from the group consisting of $SiOx$ ($0 < x \leq 2$), $SnO$ and $SnO_2$.

In the present invention, the lithium diffusion rate control layer includes one or two or more selected from the group consisting of $Al_2O_3$, $TiO_2$, $ZrO_2$, $HfO_2$, $Ta_2O_5$, $Nb_2O_5$, $Y_2O_3$, $CeO_2$, $SiO_2$, $La_2O_3$, $Ln_2O_3$, $Lu_2O_3$, $PrAlO_3$, $Er_2O_3$, HfAlO, HfSiO, ZrSiO, ZrAlO, HfON, HfSiON, $SrTiO_3$, $BaTiO_3$ and BST and may more preferably be $Al_2O_3$.

In an example of the present invention, a thickness ratio of the lithium diffusion rate control layer and the lithium layer may be 1 : 100 to 1 : 20000.

A method for manufacturing a lithium secondary battery of the present invention includes: a step of forming a negative electrode mixture layer on a current collector (S11); a step of forming a lithium thin film layer on a surface of a release plate (S12); a step of forming a lithium diffusion rate control layer by repeating an atomic layer deposition process of introducing a metal oxide on the lithium thin film layer (S13); a step of preparing a negative electrode by stacking products of step S11 and step S13 so that the negative electrode mixture layer and the lithium diffusion rate control layer may face each other (S14); a step of manufacturing an electrode assembly including the negative electrode prepared in the step S14 (S15); and a step of injecting an electrolyte into the electrode assembly (S16), wherein the atomic layer deposition process is performed until the thickness of the lithium diffusion rate control layer becomes 0.1 to 100 nm, and wherein the lithium diffusion rate control layer includes one or two or more selected from the group consisting of $Al_2O_3$, $TiO_2$, $ZrO_2$, $HfO_2$, $Ta_2O_5$, $Nb_2O_5$, $Y_2O_3$, $CeO_2$, $SiO_2$, $La_2O_3$, $Ln_2O_3$, $Lu_2O_3$, $PrAlO_3$, $Er_2O_3$, HfAlO, HfSiO, ZrSiO, ZrAlO, HfON, HfSiON, $SrTiO_3$, $BaTiO_3$ and BST.

A method for manufacturing a lithium secondary battery according to the present invention includes: a step of forming a negative electrode mixture layer on a current collector (S21); a step of forming a lithium diffusion rate control layer by repeating an atomic layer deposition process of introducing a metal oxide on the negative electrode mixture layer (S22); a step of manufacturing a negative electrode by laminating a lithium thin film on the lithium diffusion rate control layer (S23); a step of manufacturing an electrode assembly including the negative electrode prepared in the step S23 (S24); and a step of injecting an electrolyte into the electrode assembly (S25), wherein the atomic layer deposition process is performed until the thickness of the lithium diffusion rate control layer becomes 0.1 to 100 nm, and wherein the lithium diffusion rate control layer includes one or two or more selected from the group consisting of Al2O3, TiO2, ZrO2, HfO2, Ta2O5, Nb2O5, Y2O3, CeO2, SiO2, La2O3, Ln2O3, Lu2O3, PrAlO3, Er2O3, HfAlO, HfSiO, ZrSiO, ZrAlO, HfON, HfSiON, SrTiO3, BaTiO3 and BST.

Herein, the lithium diffusion rate control layer may control diffusion of lithium from the lithium layer to the negative electrode mixture layer until injection of an electrolyte.

According to an example of the present invention, a thickness of the lithium diffusion rate control layer is preferably 0.5 to 50 nm.

According to an example of the present invention, the atomic layer deposition process of the step S13 or the step S22 may include: a step of positioning a product the step S12 or the S21 in a chamber; a step of supplying metal atoms into the chamber; a step of supplying a purge gas into the chamber; a step of supplying an oxidant into the chamber to form a metal oxide layer; and a step of supplying the purge gas into the chamber to remove an unreacted oxidant.

[Advantageous Effects]

Since the negative electrode according to the present invention includes a lithium diffusion rate control layer between the lithium thin film and the negative electrode mixture layer, the rate of diffusion of lithium may be controlled in the prelithiation process, and cycle characteristics may be improved by suppressing loss of lithium or side reaction of lithium.

In addition, the manufacturing method of the lithium ion secondary battery according to the present invention has an advantage of minimizing the increase in resistance due to the material properties of the lithium diffusion rate control layer by forming a very thin lithium diffusion rate control layer by an atomic layer deposition method.

[Brief Description of the Drawings]

FIG. 1 is a schematic view showing the structure of a negative electrode according to an embodiment of the present invention.

FIGS. 2 and 3 schematically show a method of manufacturing a negative electrode according to an embodiment of the present invention.

FIGS. 4 to 8 are schematic views showing an atomic layer deposition process for forming a lithium diffusion rate control layer of the present invention.

[Detailed Description of the Preferred Embodiments]

The terms and words used in the present specification and claims should not be construed as limited to ordinary or dictionary terms and the inventor may properly define the concept of the terms in order to best describe its invention. The terms and words should be construed as meaning and concept consistent with the technical idea of the present invention. Accordingly, the embodiments described in the specification and the configurations described in the drawings are only the most preferred embodiments of the present invention, and do not represent all of the technical ideas of the present invention.

In the present specification, when a part is "connected" to another part, this includes not only "directly connected" but also "electrically connected" between the parts while having another element therebewteen.

Also, throughout the specification, when an element is referred to as "including" an element, it is understood that the element may include other elements as well unless specifically stated otherwise.

As used throughout this specification, the terms "about", "substantially", and the like, are used to mean a value or something like this when unique manufacturing and material tolerances are presented, and the terms are used to prevent unscrupulous infringers from unfair use of the disclosure including accurate or absolute figures in order to aid in the understanding of the present disclosure.

Throughout this specification, the term "combination(s) thereof" included in the expression of the Markush form means one or more mixtures or combinations selected from the group consisting of the elements described in the Markush form representation, and it means to include one or more selected from the group consisting of the above components.

The present invention relates to a negative electrode for an electrochemical device and an electrochemical device having the same. In the present invention, the electrochemical device includes all devices that undergo an electrochemical reaction, and specific examples thereof include all kinds of primary and secondary cells, fuel cells, solar cells, or capacitors. In particular, a lithium secondary battery such as a lithium metal secondary battery, a lithium ion secondary battery, a lithium polymer secondary battery or a lithium ion polymer secondary battery is preferable among the secondary batteries .

Throughout this specification, the expression "A and/or B" means "A or B or both."

Hereinafter, the present invention will be described in detail.

As a negative electrode active material, a material of silicon or carbon material inevitably causes a decrease in battery capacity due to high initial irreversible characteristics. As one of the methods to solve this problem, a prelithiation technology for pre-inserting lithium into a negative electrode has been attempted. Among them, the lithium direct contact method is a method of directly laminating thin film lithium on the negative electrode layer, and after the cell assembly, the electrolyte is injected to move the lithium of the lithium layer to the negative electrode (diffusion) to increase the lithium content in the negative electrode, to thereby solve the problem of irreversible capacity reduction.

However, in the manufacture of a lithium secondary ion battery, it often happens that time is delayed when electrolyte is injected after cell assembly. Herein, before the injection of the electrolyte, lithium of the lithium layer attached to the negative electrode may be unevenly moved into the electrode (solid-diffusion), thereby increasing resistance, or lithium may be diffused into the air, causing a problem of loss of lithium amount.

Accordingly, the present invention discloses a new electrode structure and a lithium secondary battery having the same by interposing a lithium diffusion rate control layer between a negative electrode mixture layer and a lithium layer to solve the above problems.

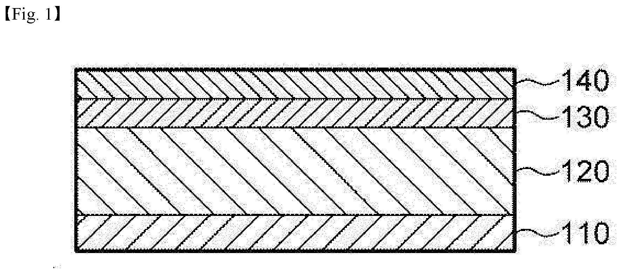

FIG. 1 is a cross-sectional view of a negative electrode 100 according to an embodiment of the present invention, specifically showing a negative electrode structure before prelithiation. Referring to FIG. 1, the negative electrode 100 includes a current collector 110; a negative electrode mixture layer 120 formed on the current collector 110; a lithium diffusion rate control layer 130 formed on the negative electrode mixture layer 120 by atomic layer deposition; and a lithium layer 140 formed on the lithium diffusion rate control layer 130.

The negative electrode 100 of the present invention is provided with a lithium diffusion rate control layer 130 between the negative electrode mixture layer 120 and the lithium layer 140 to control (mitigate) the diffusion rate of lithium from the lithium layer and help the diffusion of lithium in a uniform distribution into the negative electrode mixture layer.

As described later, in the present invention, prelithiation is performed during electrolyte injection and/or initial charge and discharge. Accordingly, the lithium diffusion rate control layer functions as a diffusion preventing layer for preventing lithium diffusion until the electrolyte injection and/or the initial charge and discharge time. On the other hand, after performing the prelithiation process, the lithium diffusion rate control layer may function as an insulating layer between the negative electrode and the positive electrode when eluted and removed or remaining in the electrolyte.

Furthermore, the lithium diffusion rate control layer 130 of the present invention is formed by atomic layer deposition to improve the problem of increasing the resistance of the lithium diffusion rate control layer by implementing a thin thickness of the nanometer level unit. In forming a lithium diffusion rate control layer, it is conventionally based on a simple application or coating of a polymer solution. In such a case, it is difficult to realize a thin film of several or tens of nanometers and the rate control layer may have a thickness of several to several hundred micrometers. Herein, if the rate control layer has a thickness of several to several hundred micrometers, the resistance of the battery may increase. However, in the present invention, since the rate control layer is formed by atomic layer deposition, a thin film of several to several tens of nanometers can be realized.

Hereinafter, the lithium diffusion rate control layer will be described in more detail.

According to the present invention, the rate control layer includes a metal oxide or metalloid oxide material having insulating properties. Specifically, $Al_2O_3$, $TiO_2$, $ZrO_2$, $HfO_2$, $Ta_2O_5$, $Nb_2O_5$, $Y_2O_3$, $CeO_2$, $SiO_2$, $La_2O_3$, $Ln_2O_3$, $Lu_2O_3$, $PrAlO_3$, $Er_2O_3$, HfAlO, HfSiO, ZrSiO, ZrAlO, HfON, HfSiON, $SrTiO_3$, $BaTiO_3$ and Barium strontium titanate oxide (BST) are included.

By interposing the (quasi) metal oxide having insulating properties between the negative electrode mixture layer and the lithium layer, the lithium of the lithium layer is prevented from being diffused into the negative electrode mixture layer until the injection of the electrolyte or the initial charge and discharge. On the other hand, after the prelithiation, the remaining metal oxide layer protects the surface of the negative electrode, thereby improving the safety of the battery at high temperatures. In this respect, $Al_2O_3$, $TiO_2$, $ZrO_2$, $CeO_2$, $Y_2O_3$, $SiO_2$ may be said to be preferable as materials forming the rate control layer of the present invention, and the most preferred material is $Al_2O_3$ . $Al_2O_3$ is the most suitable material to be applied as a lithium diffusion rate control layer of the present invention since the precursor for the atomic layer deposition process is easy to obtain and the price is low, and the research on the atomic layer deposition method is most actively conducted.

In the present invention, since the lithium diffusion rate control layer needs to be compressed to allow the lithium layer and the negative electrode mixture layer to be energized under the activation pressure range applied during the first charge/discharge, the lithium diffusion rate control layer is formed by an atomic layer deposition method in order to realize a thin thickness of the lithium diffusion rate control layer,

The lithium diffusion rate control layer has a thickness of 0.1 to 100 nm, more preferably 0.5 to 50 nm. When the thickness of the lithium diffusion rate control layer is too thin as less than 0.1 nm, an electric current may be applied before performing the prelithiation process after attaching the lithium thin film, thereby making it difficult to exert a function as a lithium diffusion rate preventing layer, resulting in uneven lithiation. On the contrary, when the thickness of the lithium diffusion rate control layer is too thick as 100 nm or more, it may be difficult to smoothly diffuse lithium into the negative electrode due to the interruption of energization of the lithium layer and the negative electrode, and the resistance may increase.

By providing a rate control layer having the above-mentioned characteristics, there is an effect of reducing the amount of lithium loss and the amount of lithium side reaction by reducing the diffusion of lithium before the electrolyte injection, and the increase in resistance can be minimized by allowing the rate control layer to have a thickness of tens of nanometers.

The lithium diffusion rate control layer may be a single layer, but may have a two-layer structure of the first lithium diffusion rate control layer and the second lithium diffusion rate control layer, and if necessary, may have a multilayer structure of three or more layers. At this time, the materials of respective layers constituting the lithium diffusion rate control layer may be different kinds or may be a metal oxide of the same kind.

Hereinafter, the lithium layer will be described in detail.

The lithium layer is used as a source for lithiating the negative electrode active material included in the negative electrode mixture layer, and after a certain period of time from electrolyte injection, a certain amount of lithium layer participates in the prelithiation and moves into the negative electrode mixture layer. Even after prelithiation is completed to some extent, the residual amount may exist on the surface of the rate control layer.

The lithium layer contains lithium metal. In one specific embodiment of the present invention, the lithium layer may be formed by electroplating, electrolytic plating, chemical vapor deposition, or may be laminated by binding a lithium metal thin film to the rate control layer by compression.

The thickness of the lithium layer may be appropriately selected in consideration of the loading amount of the negative electrode, and specifically, has a thickness of 0.1 $\mu$m to 40 $\mu$m, preferably 1 $\mu$m to 20 $\mu$m.

The thickness ratio of the lithium diffusion rate control layer and the lithium layer may be 1 : 100 to 1 : 20000. If the lithium diffusion rate control layer is too thick beyond the above ratio, lithiation may be insufficient and the irreversible capacity may increase. On the contrary, when the lithium diffusion rate control layer is too thin, it is energized after the lithium thin film is attached and before performing the prelithiation process, and thus it is difficult to function as a lithium diffusion rate preventing layer.

Hereinafter, the current collector and the negative electrode mixture layer constituting the negative electrode of the present invention will be described in detail.

The current collector is generally made of a thickness of 3 $\mu$m to 500 $\mu$m. The current collector is not particularly limited as long as it has high conductivity without causing a chemical change in the battery. For example, the current collector may be made of a metal such as stainless steel, aluminum, nickel, titanium, sintered carbon, cooper, or aluminum or stainless steel of which the surface is treated with carbon, nickel, titanium, or silver, or the like.

The negative electrode mixture layer includes a negative electrode active material, a binder, and a conductive material. The negative electrode according to the present invention may be prepared by applying a mixture of a negative electrode active material, a conductive material and a binder on the current collector and then drying them, and may further include a filler in the mixture, if necessary.

In one specific embodiment of the present invention, the negative electrode active material includes a (semi) metal oxide, and the (semi) metal oxide may be in the form of particles or powder including the particles.

The (semi) metal compound is at least one selected from the group consisting of Si, Sn, Al, Sb, Bi, As, Ge, Pb, Zn, Cd, In, TI, Ga and alloys thereof. Preferably, the negative electrode active material may include one or a mixture of two or more compounds selected from the group consisting of $SiO_x$ (0< x$\leq$ 2), SnO and $SnO_2$.

On the other hand, in one specific embodiment of the present invention, the metal oxide may be provided with a shell portion containing a carbon material on at least part of the surface of the particle. The carbon material may be bonded, attached or coated on the surface of the (quasi) metal oxide particles. The carbon material may include at least one selected from the group consisting of crystalline carbon, natural graphite, artificial graphite, kish graphite, graphitized carbon fiber, graphitized mesocarbon microbeads, and amorphous carbon. In addition, the graphite may include those obtained by graphitizing one or more selected from the group consisting of soft carbon, hard carbon, pyrolytic carbon, mesophase pitch based carbon fiber, meso-carbon microbeads, mesophase pitches, petroleum or coal tar pitch derived cokes and activated carbon.

According to a preferred embodiment of the present invention, the 50% particle size ($D_{50}$) of the metal oxide volume cumulative particle size distribution is 2 $\mu$m or more and 5 $\mu$m or less. The 90% particle size ($D_{90}$) of the volume cumulative particle size distribution of the particles is 25 $\mu$m or less, preferably 15 $\mu$m or less, and more preferably 10 $\mu$m or less. Moreover, the maximum particle diameter of a volume cumulative particle size distribution is 35 micrometers or less, preferably 25 micrometers or less. The measurement of 50% particle size, 90% particle size and maximum particle size of the volume cumulative particle size distribution can be obtained by, for example, the cumulative frequency when measured using a laser diffraction particle size distribution measuring device manufactured by Nikkiso.

The binder is added in an amount of 1 to 30% by weight, on the basis of the total weight of the electrode mixture, as a component that assists in bonding between the active material and the conductive material and bonding to the current collector. The high molecular weight polyacrylonitrile-acrylic acid copolymer may be used as such a binder, but is not limited thereto. Other examples include polyvinylidene fluoride, polyvinyl alcohol, carboxymethyl cellulose, starch, hydroxypropyl cellulose, recycled cellulose, polyvinylpyrrolidone, tetrafluoroethylene, polyethylene, polypropylene, ethylene-propylene-diene, sulfonated EDPM, styrene rubber, butylene rubber, fluorine rubber, etc. which are various copolymers.

The conductive material is usually added in an amount of 1 to 30% by weight based on the total weight of the mixture including the negative electrode active material. Such a conductive material is not particularly limited as long as it has electrical conductivity without causing a chemical change in the battery, and examples thereof include graphite such as natural graphite and artificial graphite; carbon black such as carbon black, acetylene black, Ketjen black, channel black, furnace black, lamp black, and thermal black; conductive fibers such as carbon fiber and metal fiber; metal powders such as carbon fluoride, aluminum and nickel powder; conductive whiskey such as zinc oxide and potassium titanate; conductive metal oxides such as titanium oxide; and conductive materials such as polyphenylene derivatives and the like, but the present invention is not limited to these examples.

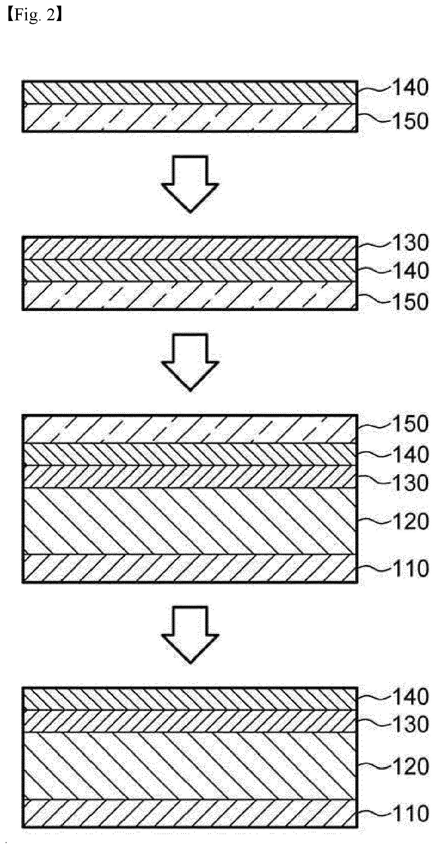

In the present invention, the negative electrode may be prepared in the following order. First, a negative electrode mixture layer is formed on the surface of the current collector (S11). Next, a release plate is prepared and a lithium thin film is laminated on its surface to form a lithium thin film layer (S12). Subsequently, an atomic layer deposition process of introducing a metal oxide on the lithium thin film layer is repeated to form a lithium diffusion rate control layer (S13). In the present invention, the release plate may be used without limitation as long as the release plate can be easily removed from the laminate produced by sequentially stacking the lithium layer and the lithium diffusion rate control layer. For example, the release plate may be a resin film layer made of polyethylene terephthalate. Next, a negative electrode is manufactured by stacking the products of step S11 and step S13 so that the negative electrode mixture layer and the lithium diffusion rate control layer may face each other (S14). FIG. 2 is a schematic diagram illustrating the above-described negative electrode manufacturing method. Subsequently, a secondary battery may be manufactured by assembling an electrode assembly by interposing a separator in a space between the negative electrode and the positive electrode (S15) and injecting an electrolyte into the electrode assembly (S16).

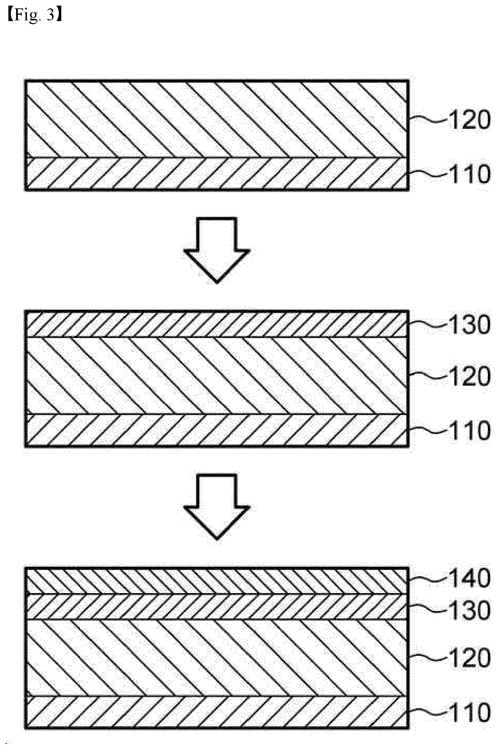

Alternatively, the negative electrode according to the present invention may be manufactured by a method of forming a lithium diffusion rate control layer on the negative electrode mixture layer and then forming a lithium layer on the surface of the control layer, without using a release plate. Specifically, the method may include: forming a negative electrode mixture layer on the current collector (S21); repeating an atomic layer deposition process of introducing metal oxide on the negative electrode mixture layer to form a lithium diffusion rate control layer (S22); stacking a lithium thin film on the lithium diffusion rate control layer to manufacture a negative electrode (S23); preparing an electrode assembly including the negative electrode prepared in the step S23; and injecting an electrolyte into the electrode assembly (S25). Here, the formation of the lithium layer and the formation of the lithium diffusion rate control layer may be understood by referring to the above-described method. FIG. 3 is a schematic diagram illustrating the above-described negative electrode manufacturing method.

Hereinafter, the atomic layer deposition process of the present invention will be described in detail.

An atomic layer deposition (ALD) is a self-controlled deposition process, and has been selected as a method of forming the rate control layer of the present invention because deposition can be performed by precisely controlling the thickness of the thin film.

In the present invention, a lithium diffusion rate control layer was formed on the lithium thin film layer of the product of step S12 or the negative electrode mixture layer of the product of step S21 by using the polymer precursor as a raw material of the deposition process.

The atomic layer deposition process includes: placing the result of the step S12 or the result of the step S21 in the chamber (S31); supplying metal atoms into the chamber; supplying a purge gas into the chamber; supplying an oxidant in the chamber to form a metal oxide layer; and supplying a purge gas into the chamber to remove unreacted oxidant.

When placing the resultant of the step S12 or the resultant of the step S21 in the chamber, it is preferable to maintain the temperature inside the chamber at 100 to 500°C. If the temperature of the chamber is less than 100°C, the reactivity of the reactant is not easy in a subsequent process, and if it exceeds 500°C, the crystallization of the metal oxide thin film is not performed, which is not preferable.

In addition, the pressure inside the chamber is preferably adjusted to be 0.1 to 3.0 torr. If the pressure is less than 0.1 torr, the reactivity of the metal atoms supplied in the subsequent process is not easy, and if it exceeds 3.0 torr, it is not preferable because the process control is not easy.

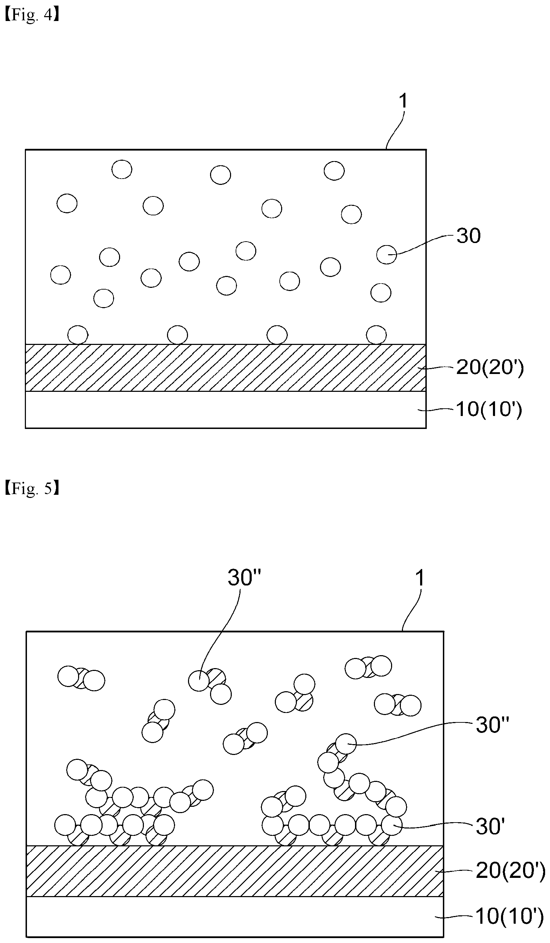

Referring to FIG. 4, after placing the resultant of the step S12 or the resultant of the step S21 in the chamber 1 that satisfies the above temperature and pressure conditions, the (semi) metal or (semi) metal precursor is added as a reactant. The (semi) metal or (semi) metal precursor may contain one or more atoms 30 selected from the group consisting of Al, Ti, Zr, Hf, Ta, Nb, Y, Ce, Si, La, Ln, Lu, Pr, Er, Sr and Ba.

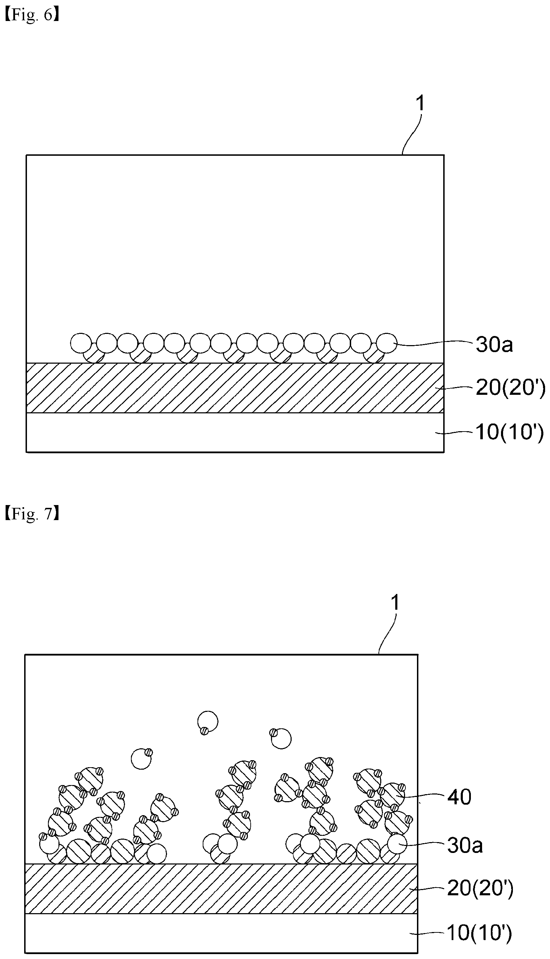

Thereafter, referring to FIG. 5, the first portion 30' of the (quasi) metal atom is chemisorbed on the lithium thin film layer 20 or the negative electrode mixture layer 20' by providing a (semi) metal or (semi) metal precursor material to each lithium thin film layer 20 or the negative electrode mixture layer 20' of the result of the step S12 or the result of the step S21 located in the chamber like the above. The second portion 30", except for the first portion of the metal atom, is physically adsorbed to the first portion or drifted on the chamber. The next step is to provide a purge gas into the chamber. Examples of the purge gas may include an inert gas such as argon gas or nitrogen gas. At this time, the purge gas may be provided for about 1 to 50 seconds, more preferably 3 to 25 seconds, most preferably 5 to 10 seconds. By providing the purge gas into the chamber as described above, the second portion drifting in the chamber or physically adsorbed to the first portion is removed as shown in FIG. 6. As a result, the precursor molecules 30a of the chemisorbed first portion remain on the lithium thin film layer or the negative electrode mixture layer.

Instead of providing the purge gas, even if the vacuum inside the chamber is maintained for about 1 to 20 seconds, it is possible to remove the second portion that floats in the chamber or is physically adsorbed to the first portion.

In addition, the introduction of the purge gas and the vacuum purge may be performed together to remove the second part drifting in the chamber or physically adsorbed to the first part.

Next, as shown in FIG. 7, after the above steps, the oxidant 40 is supplied into the chamber. As an example of the oxidant, one selected from the group consisting of $O_3$, $O_2$, $H_2O$, plasma $O_2$, and remote plasma $O_2$ may be used alone, or two or more may be mixed and used in some cases.

In the present invention, it is preferable to supply the oxidant for about 0.5 to 10 seconds into the chamber. The oxidant chemically reacts with the precursor molecules 30a which are the first portions of the reaction material chemisorbed on the negative electrode mixture layer or the lithium thin film layer to thereby oxidize the precursor molecules.

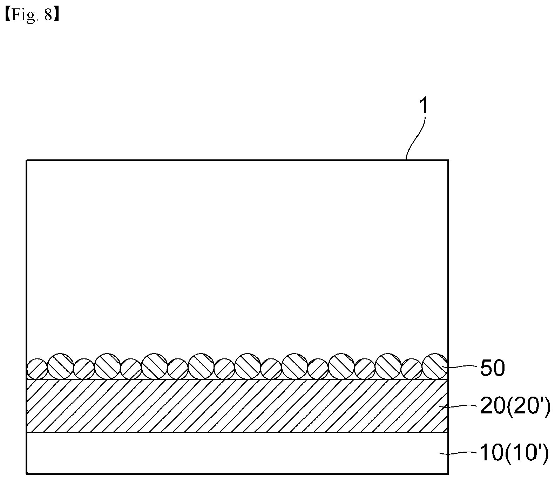

Next, a purge gas of the same kind as described above is supplied to remove the oxidant which has not reacted with the first portion of the metal atom. The type and introduction time of the purge gas are the same as described above. As such, by providing a purge gas into the chamber, an oxidant that is not chemically reacted with the metal atoms is removed from the chamber as shown in FIG. 8. Accordingly, the metal oxide layer 50 is formed on the lithium thin film layer or the negative electrode mixture layer.

If necessary, the above steps may be repeated at least once or more. In this case, the thickness of the metal oxide layer on the lithium thin film layer or the negative electrode mixture layer is adjusted according to the number of repetitions of the processes.

According to an embodiment of the present invention, after placing the output of the step S12 or the output of the step S21 in the chamber, the (semi) metal or (semi) metal precursor material, the purge gas and the oxidant may be supplied together to form the metal oxide layer.

Hereinafter, the (pre) lithiation process of the present invention will be described in detail.

In one embodiment of the present invention, the (pre) lithiation of the negative electrode proceeds during electrolyte injection and/or initial charge/discharge step after fabrication of the battery, and at least a part of the negative electrode active material included in the negative electrode mixture layer is lithiated. In one embodiment of the present invention, the battery includes an electrode assembly consisting of a negative electrode, a positive electrode, and a separator interposed between the negative electrode and the positive electrode, and the electrode assembly is inserted into a suitable exterior material and the electrolyte may be injected and sealed.

In the present invention, lithiation may proceed by injecting the electrolyte. In other words, when the electrolyte is injected, the electrode assembly including components such as an electrode is impregnated in the electrolyte. At this time, while the lithium diffusion rate control layer of the present invention is eluted and removed, lithium of the lithium layer may be diffused into the negative electrode mixture layer.

After the electrolyte injection, the battery is activated by first applying a current to perform initial charge/discharge (formation). The activation process may be performed while a predetermined pressure is applied to the battery. As described above, in the case of using a material, which may be compressed under a predetermined pressure and energized, as a control layer, lithium may be diffused into the negative electrode mixture layer through an activation process under a predetermined pressure.

By this prelithiation, the negative electrode active material included in the negative electrode mixture layer, in particular, the (quasi) metal oxide and lithium described above may be combined to form an alloy. In addition, a part of lithium may be inserted into the crystal structure of the negative electrode active material. In addition, the lithium ion can be well delivered to the inside of the negative electrode through the electrolyte in the process of prelithiation, and thus there is an advantage that uniform prelithiation can be performed over the entire body of the negative electrode.

In the present invention, since the rate control layer is interposed between the negative electrode mixture layer and the lithium layer, diffusion of lithium is prevented by the control layer in the state before the injection of the electrolyte, and almost no lithiation proceeds. Almost all prelithiation can be performed after the injection of the electrolyte into the electrode assembly and/or at the first charge and discharge step.

On the other hand, the first charge and discharge is preferably carried out in a state in which a predetermined pressure is applied to the battery in order to energize the control layer and the negative electrode. Thereafter, as long as lithium metal remains in the lithium layer, the prelithiation may be continuously performed and may be affected, for example, may be accelerated by the charge/discharge of the battery.

Hereinafter, the (pre) lithiation process of the present invention will be described in detail.

The present invention provides a lithium secondary battery including a negative electrode, a positive electrode, a separator interposed between the negative electrode and the positive electrode, and an electrolyte, and the negative electrode has the above-described configuration features.

The positive electrode is prepared by applying a mixture of a positive electrode active material, a conductive material and a binder on a positive electrode current collector, followed by drying. If necessary, a filler may be further added to the mixture. The positive electrode active material may be a layered compound such as lithium cobalt oxide ($LiCoO_2$), lithium nickel oxide ($LiNiO_2$), or a compound substituted with one or more transition metals; lithium manganese oxides such as $Li_{1+x}Mn_{2-x}O_4$ (herein, x is between 0 and 0.33), $LiMnO_3$, $LiMn_2O_3$, and $LiMnO_2$; lithium copper oxide ($Li_2CuO_2$); vanadium oxides such as $LiV_3O_8$, $LiFe_3O_4$, $V_2O_5$, and $Cu_2V_2O_7$; lithium nickel oxide expressed by $LiNi_{1-x}M_xO_2$ (herein, M = Co, Mn, Al, Cu, Fe, Mg, B or Ga, and x = 0.01 to 0.3); a lithium manganese compound oxide expressed by $LiMn_{2-x}M_xO_2$ (where M = Co, Ni, Fe, Cr, Zn or Ta and x = 0.01 to 0.1) or $Li_2Mn_3MO_8$ (where M = Fe, Co, Ni, Cu or Zn); $LiMn_2O_4$ in which a part of Li is substituted with an alkaline earth metal ion; disulfide compounds; $Fe_2(MoO_4)_3$, etc., but not limited thereto.

In the case of the positive electrode, the conductive material, the current collector, and the binder may be understood by referring to the above description about the negative electrode.

The separator may be formed of an insulating thin film having high ion permeability and mechanical strength. The process diameter of the separator is generally between 0.01 and 10$\mu$m, the thickness may be between 5 and 300$\mu$m. Examples of such a separator include olefin-based polymers such as polypropylene which is chemically resistant and hydrophobic; a sheet or a nonwoven fabric made of glass fiber, polyethylene or the like. When a solid electrolyte such as a polymer is used as the electrolyte, the solid electrolyte may also serve as a separator.

In the present invention, the electrolyte solution contains an organic solvent and a predetermined amount of lithium salt, and examples of components of the organic solvent may include aprotic organic solvents such as N-methyl-2-pyrrolidinone, propylene carbonate, ethylene carbonate, butylene carbonate, dimethyl carbonate, diethyl carbonate, gamma-butylo lactone, 1,2-dimethoxy ethane, tetrahydroxy franc, 2-methyl tetrahydrofuran, dimethyl sulfoxide, 1,3-dioxolon, formamide, dimethylformamide, dioxorone, acetonitrile, nitromethane, methyl formate, methyl acetate, phosphate triester, trimethoxy methane, dioxon derivatives, sulfolane, methyl sulfolane, 1,3-dimethyl-2-imidazolidinone, propylene carbonate derivatives, tetrahydrofuran derivatives, ethers, methyl pyroionate and ethyl propionate.

The lithium salt is a substance that is soluble in the electrolyte. The examples of the lithium salt include LiCl, LiBr, LiI, $LiClO_4$, $LiBF_4$, $LiB_{10}Cl_{10}$, $LiPF_6$, $LiCF_3SO_3$, $LiCF_3CO_2$, $LiAsF_6$, $LiSbF_6$, $LiAlCl_4$, $CH_3SO_3Li$, $CF_3SO_3Li$, $(CF_3SO_2)_2NLi$, chloroborane lithium, lower aliphatic carboxylic acid lithium, lithium 4-phenylborate, imide and the like.

The secondary battery of the present invention may be manufactured by accommodating/sealing the electrode assembly, in which the positive electrode and the negative electrode are alternately stacked with a separator, in an exterior material such as a battery case together with the electrolyte. The manufacturing method of a secondary battery can use a conventional method without limitation.

According to another example of the present invention, there is provided a battery module including the secondary battery as a unit cell and a battery pack including the same. Since the battery module and the battery pack include a secondary battery exhibiting excellent fast charging characteristics in high loading, the battery module and the battery pack may be used as a power source for an electric vehicle, a hybrid electric vehicle, a plug-in hybrid electric vehicle, and a power storage system.

Meanwhile, with respect to battery elements, for example, conductive materials, which are not described in detail herein, reference may be made to elements commonly used in the battery field, particularly in the lithium secondary battery field.

Hereinafter, the present invention will be described in detail with reference to examples. However, the embodiments according to the present invention may be modified into various other forms, and the scope of the present invention should not be construed as being limited to the examples described below. The examples of the present invention are provided to more fully describe the present invention to those skilled in the art.

Preparation example of negative electrode

SiO (D50: 3.2 $\mu$m) and artificial graphite were mixed at a weight ratio of 3 : 7 to be used as a negative electrode active material. The negative electrode active material, SBR binder, CMC and acetylene black were added to water in a weight ratio of 93 : 3 : 1.5 : 2.5 to prepare a negative electrode mixture. The mixture was uniformly coated on 10 $\mu$m copper foil, the drying temperature was 90°C, and the coating rate was 0.2 m/min. The coated negative electrode was rolled to match the porosity of 30% to meet the target thickness. Then, it was dried for 12 hours in a 180 °C vacuum oven.

Example 1

Fabrication of negative electrode with lithium diffusion rate control layer and lithium layer

The negative electrode of the above preparation example was placed in a chamber (150°C, 0.1 torr), and trimethylaluminum and $H_2O$ gas were injected with a pressure of 1 torr nitrogen gas at a ratio of 17 : 1. The atomic layer deposition process was repeatedly performed until the thickness of the $Al_2O_3$ layer became about 3 nm on the negative electrode mixture layer by the following reactions (A) and (B).

(A) Al-OH* + Al(CH$_3$)$_3$ + Al-O- Al(CH$_3$)$_2$* + CH$_4$
(B) Al-CH$_3$* +H$_2$O + Al-OH* + CH$_4$

Then, a negative electrode was prepared by laminating a lithium thin film having a thickness of 10 $\mu$m.

Preparation of Half Coin Cell

Coin cells were prepared in the order of negative electrode/separator (porous film made of polypropylene (20 $\mu$m,Celgard))/lithium foil by using lithium foil and stainless steel upper and lower plates as counter electrodes of the obtained negative electrode and prepared negative electrode. The electrolyte was injected immediately after assembling the coin cell. At this time, the electrolyte is a mixture of ethylene carbonate and ethyl methyl carbonate in a mass ratio of 3 : 7.

Example 2

A battery was manufactured in the same manner as in Example 1, except that the injection time of the electrolyte was changed to a time after 2 hours from the assembly of the coin cell.

Comparative Example 1

A battery was manufactured in the same manner as in Example 1, except that an atomic layer deposition process for forming an $Al_2O_3$ layer on the negative electrode mixture layer was omitted in Example 1.

Comparative Example 2

A battery was manufactured in the same manner as in Comparative Example 1, except that the injection time of the electrolyte was changed to a time after 2 hours from the assembly of the coin cell.

Example 3

Preparation Example of positive electrode

LiCoO$_2$ SBR binder, CMC and acetylene black as the positive electrode active material were added to water in a weight ratio of 93 : 3 : 1.5 : 2.5 to prepare a positive electrode mixture. The mixture was uniformly coated on 10 $\mu$m aluminum foil and dried for 12 hours in a 50°C vacuum oven to prepare a positive electrode.

Preparation of Mono Cells

1-stack mono cells were prepared in the order of a negative electrode/separator (polypropylene material porous film; 20 $\mu$m, Celgard)/positive electrode, using a positive electrode and a negative electrode having a lithium diffusion rate control layer and a lithium layer prepared in Example 1. The electrolyte was injected after 2 hours from the assembly of the mono cells At this time, the electrolyte is a mixture of ethylene carbonate and ethyl methyl carbonate in a mass ratio of 3 : 7.

Comparative Example 3

After preparing the negative electrode prepared in Comparative Example 1 and the positive electrode prepared in Example 3, 1-stack mono cells were prepared in the order of negative electrode/separator (porous film made of polypropylene (20$\mu$m, Celgard))/positive electrode. The electrolyte was injected after 2 hours from the assembly of the mono cells At this time, the electrolyte is a mixture of ethylene carbonate and ethyl methyl carbonate in a mass ratio of 3 : 7.

Comparative Example 4

Preparation of Negative Electrode with Lithium Diffusion Rate Control Layer Prepared by Coating Method

In preparing a negative electrode having a lithium diffusion rate control layer and a lithium layer in Example 1, a polymethyl methacrylate solution (0.5wt% PMMA (Mw: 890k) in anisole solution) on a negative electrode mixture layer was coated by a solution casting method and dried for 24 hours at 80°C to form a lithium diffusion rate control layer. Thereafter, a negative electrode was prepared in the same manner as in Example 1. The thickness of the polymethyl methacrylate layer is 200 nm.

Preparation of Mono Cells

After preparing the negative electrode prepared and the positive electrode prepared in Example 3, 1-stack mono cells were prepared in the order of negative electrode/separator (porous film made of polypropylene ($20\mu m$, Celgard))/positive electrode. The electrolyte was injected after 2 hours from the assembly of the mono cells At this time, the electrolyte is a mixture of ethylene carbonate and ethyl methyl carbonate in a mass ratio of 3 : 7.

Experimental Example 1

In each of the Examples and Comparative Examples, the first discharge was first performed at 0.1 C, up to 1.5 V in CC mode, followed by charging at 0.1 C, 5 mV, and 0.005 C cut conditions in CC/CV mode, and discharging at 0.1 C, up to 1.5 V in CC mode, to thereby perform the irreversible capacity at the first charge and discharge. Total dosage is the sum of Li intercalation capacity and SEI production capacity. Here, the Li intercalation capacity can be obtained by measuring the first capacity up to 1.5V discharge to obtain the capacity of lithium inserted into the negative electrode. The SEI generation capacity would also limit the 1st irreversible capacity of the lithiated negative electrode from the 1st irreversible capacity of the negative electrode prior to lithiation.

[Table 1]

| Electrolyte injection time point | Division | Total dosage (mAh/cm$^2$) |
|---|---|---|
| Immediately after cell production | Comparative Example 1 | 1.40 |
| | Example 1 | 1.41 |
| 2 hours after cell production | Comparative Example 2 | 1.17 |
| | Comparative Example 3 | 1.17 |
| | Comparative Example 4 | 1.40 |
| | Example 2 | 1.38 |
| | Example 3 | 1.41 |

Example 1 and Comparative Example 1 in which the electrolyte was injected immediately after fabrication of the coin cell were found to have similar amounts of lithiation. However, when the electrolyte was injected after 2 hours from cell fabrication, Comparative Examples 2 and 3, which did not include the lithium diffusion rate control layer, had a significantly low amount lithiation compared to that of Examples 2 and 3 and Comparative Example 4 which included a lithium diffusion rate control layer. Accordingly, it was found that the loss of lithium was less before lithiation in the negative electrode having the lithium diffusion rate control layer of the present invention.

Experimental Example 2

For the batteries of Example 3 and Comparative Examples 3 and 4, in order to measure the resistance, 2.5C discharge current was applied for 30 seconds in the SOC 50 state, and the resistance was substituted by the following equation through the voltage change before and after applying the current. Then the measurement results are shown in Table 2.

EP 3 796 428 B1

$$Resistance = (Vi-Vf) / I$$

(In the above formula, Vi is the voltage before applying the current, Vf is the voltage after applying the current, and I is the amount of current)

[Table 2]

| Electrolyte injection time point | Division | Resistance (@SOC 50, ohm) |
|---|---|---|
| 2 hours after cell production | Comparative Example 3 | 0.83 |
| | Comparative Example 4 | 1.05 |
| | Example 3 | 0.75 |

Since the comparative example 3 does not have a lithium diffusion rate control layer, its resistance value is low, compared with that of the comparative example 4 provided with a lithium diffusion rate control layer. Example 3 has a lithium diffusion rate control layer as in Comparative Example 4, but because the lithium diffusion rate control layer is much thinner than that of Comparative Example 4, it can be seen that the resistance is low, which is equivalent to or lower than that of the comparative example 3 which is not equipped with a lithium diffusion rate control layer. Accordingly, it was found that the negative electrode with the lithium diffusion rate control layer of the present invention did not show an increase in the resistance.

[Description of Symbols]

1: chamber
30: metal atom
30': first portion of chemisorbed metal atoms
30": second portion of physisorbed or drift metal atom
30a: first partial precursor of chemisorbed metal atoms
40: oxidizing agent
50: metal oxide layer
100: negative electrode
10', 110: current collector
20', 120: negative electrode mixture layer
130: lithium diffusion rate control layer
20, 140: lithium layer
10, 150: release plate

**Claims**

1. A negative electrode for a lithium secondary battery, comprising:

   a current collector;
   a negative electrode mixture layer formed on the current collector;
   a lithium diffusion rate control layer formed on the negative electrode mixture layer by atomic layer deposition; and
   a lithium layer formed on the lithium diffusion rate control layer,
   wherein the lithium diffusion rate control layer includes one or two or more selected from the group consisting of $Al_2O_3$, $TiO_2$, $ZrO_2$, $HfO_2$, $Ta_2O_5$, $Nb_2O_5$, $Y_2O_3$, $CeO_2$, $SiO_2$, $La_2O_3$, $Ln_2O_3$, $Lu_2O_3$, $PrAlO_3$, $Er_2O_3$, HfAlO, HfSiO, ZrSiO, ZrAlO, HfON, HfSiON, $SrTiO_3$, $BaTiO_3$ and BST, and
   wherein a thickness of the lithium diffusion rate control layer is 0.1 to 100 nm.

2. The negative electrode of claim 1, wherein the lithium diffusion rate control layer controls diffusion of lithium from the lithium layer to the negative electrode mixture layer until injection of an electrolyte.

13

3. The negative electrode of claim 1, wherein the lithium diffusion rate control layer controls diffusion of lithium from the lithium layer to the negative electrode mixture layer until a first charge/discharge.

4. The negative electrode of claim 1, wherein a thickness of the lithium diffusion rate control layer is 0.5 to 50 nm.

5. The negative electrode of claim 1, wherein the negative electrode mixture layer comprises one compound or a mixture of two or more selected from the group consisting of SiOx ($0 < x \le 2$), SnO and $SnO_2$.

6. The negative electrode of claim 1, wherein the lithium diffusion rate control layer is $Al_2O_3$.

7. The negative electrode of claim 1, wherein a thickness ratio of the lithium diffusion rate control layer and the lithium layer is 1 : 100 to 1 : 20000.

8. A method for manufacturing a lithium secondary battery, the method comprising:

   a step of forming a negative electrode mixture layer on a current collector (S11);
   a step of forming a lithium thin film layer on a surface of a release plate (S12);
   a step of forming a lithium diffusion rate control layer by repeating an atomic layer deposition process of introducing a metal oxide on the lithium thin film layer (S13);
   a step of preparing a negative electrode by stacking products of step S11 and step S13 so that the negative electrode mixture layer and the lithium diffusion rate control layer may face each other (S14);
   a step of manufacturing an electrode assembly including the negative electrode prepared in the step S14 (S15); and
   a step of injecting an electrolyte into the electrode assembly (S16),
   wherein the atomic layer deposition process is performed until the thickness of the lithium diffusion rate control layer becomes 0.1 to 100 nm, and
   wherein the lithium diffusion rate control layer includes one or two or more selected from the group consisting of $Al_2O_3$, $TiO_2$, $ZrO_2$, $HfO_2$, $Ta_2O_5$, $Nb_2O_5$, $Y_2O_3$, $CeO_2$, $SiO_2$, $La_2O_3$, $Ln_2O_3$, $Lu_2O_3$, $PrAlO_3$, $Er_2O_3$, HfAlO, HfSiO, ZrSiO, ZrAlO, HfON, HfSiON, $SrTiO_3$, $BaTiO_3$ and BST.

9. A method for manufacturing a lithium secondary battery, the method comprising:

   a step of forming a negative electrode mixture layer on a current collector (S21);
   a step of forming a lithium diffusion rate control layer by repeating an atomic layer deposition process of introducing a metal oxide on the negative electrode mixture layer (S22);
   a step of manufacturing a negative electrode by laminating a lithium thin film on the lithium diffusion rate control layer (S23);
   a step of manufacturing an electrode assembly including the negative electrode prepared in the step S23 (S24); and
   a step of injecting an electrolyte into the electrode assembly (S25),
   wherein the atomic layer deposition process is performed until the thickness of the lithium diffusion rate control layer becomes 0.1 to 100 nm, and
   wherein the lithium diffusion rate control layer includes one or two or more selected from the group consisting of $Al_2O_3$, $TiO_2$, $ZrO_2$, $HfO_2$, $Ta_2O_5$, $Nb_2O_5$, $Y_2O_3$, $CeO_2$, $SiO_2$, $La_2O_3$, $Ln_2O_3$, $Lu_2O_3$, $PrAlO_3$, $Er_2O_3$, HfAlO, HfSiO, ZrSiO, ZrAlO, HfON, HfSiON, $SrTiO_3$, $BaTiO_3$ and BST.

10. The method of any one of claims 8 and 9, wherein the atomic layer deposition process is performed until the thickness of the lithium diffusion rate control layer becomes 0.5 to 50 nm.

11. The method of claim 8, wherein the step S13 comprises:

   a step of positioning a product the step S 12 in a chamber;
   a step of supplying metal atoms into the chamber;
   a step of supplying a purge gas into the chamber;
   a step of supplying an oxidant into the chamber to form a metal oxide layer; and
   a step of supplying the purge gas into the chamber to remove an unreacted oxidant.

12. The method of claim 9, wherein the step S22 comprises:

a step of positioning a product the step S21 in a chamber;
a step of supplying metal atoms into the chamber;
a step of supplying a purge gas into the chamber;
a step of supplying an oxidant into the chamber to form a metal oxide layer; and
a step of supplying the purge gas into the chamber to remove an unreacted oxidant.

**Patentansprüche**

1. Negative Elektrode für eine Lithiumsekundärbatterie, umfassend:

    einen Stromabnehmer;
    eine Negativelektrodenmischungsschicht, die auf dem Stromabnehmer gebildet ist;
    eine Lithiumdiffusionsratenkontrollschicht, die auf der Negativelektrodenmischungsschicht durch Atomlagenabscheidung gebildet ist; und
    eine Lithiumschicht, die auf der Lithiumdiffusionsratenkontrollschicht gebildet ist,
    wobei die Lithiumdiffusionsratenkontrollschicht ein oder zwei oder mehr Vertreter, ausgewählt aus der Gruppe bestehend aus $Al_2O_3$, $TiO_2$, $ZrO_2$, $HfO_2$, $Ta_2O_5$, $Nb_2O_5$, $Y_2O_3$, $CeO_2$, $SiO_2$, $La_2O_3$, $Ln_2O_3$, $Lu_2O_3$, $PrAlO_3$, $Er_2O_3$, HfA10, HfSiO, ZrSiO, ZrA10, HfON, HfSiON, $SrTiO_3$, $BaTiO_3$ und BST, einschließt, und
    wobei eine Dicke der Lithiumdiffusionsratenkontrollschicht 0,1 bis 100 nm beträgt.

2. Negative Elektrode nach Anspruch 1, wobei die Lithiumdiffusionsratenkontrollschicht Diffusion von Lithium aus der Lithiumschicht in die Negativelektrodenmischungsschicht kontrolliert bis ein Elektrolyt injiziert wird.

3. Negative Elektrode nach Anspruch 1, wobei die Lithiumdiffusionsratenkontrollschicht Diffusion von Lithium aus der Lithiumschicht in die Negativelektrodenmischungsschicht kontrolliert bis zu einem ersten Laden/Entladen.

4. Negative Elektrode nach Anspruch 1, wobei eine Dicke der Lithiumdiffusionsratenkontrollschicht 0,5 bis 50 nm beträgt.

5. Negative Elektrode nach Anspruch 1, wobei die Negativelektrodenmischungsschicht eine Verbindung oder eine Mischung aus zwei oder mehr Vertretern, ausgewählt aus der Gruppe bestehend aus SiOx ($0<x\leq2$), SnO und $SnO_2$, umfasst.

6. Negative Elektrode nach Anspruch 1, wobei die Lithiumdiffusionsratenkontrollschicht $Al_2O_3$ ist.

7. Negative Elektrode nach Anspruch 1, wobei ein Dickenverhältnis der Lithiumdiffusionsratenkontrollschicht und der Lithiumschicht 1:100 bis 1:20000 beträgt.

8. Verfahren zur Herstellung einer Lithiumsekundärbatterie, wobei das Verfahren folgendes umfasst:

    einen Schritt, in dem eine Negativelektrodenmischungsschicht auf einem Stromabnehmer ausgebildet wird (S11);
    einen Schritt, in dem eine Lithiumdünnschicht auf einer Oberfläche einer Auslöseplatte ausgebildet wird (S12);
    einen Schritt, in dem eine Lithiumdiffusionsratenkontrollschicht ausgebildet wird durch Wiederholen eines Atomlagenabscheidungsverfahrens zum Einbringen eines Metalloxids in die Lithiumdünnschicht (S13);
    einen Schritt, in dem eine negative Elektrode hergestellt wird durch Stapeln der Produkte aus Schritt S11 und Schritt S13 in einer solchen Weise, dass die Negativelektrodenmischungsschicht und die Lithiumdiffusionsratenkontrollschicht einander gegenüberliegen können (S14);
    einen Schritt, in dem eine Elektrodenanordnung, die die in dem Schritt S14 hergestellte negative Elektrode einschließt, hergestellt wird (S15); und
    einen Schritt, in dem ein Elektrolyt in die Elektrodenanordnung injiziert wird (S16),
    wobei das Atomlagenabscheidungsverfahren durchgeführt wird bis die Dicke der Lithiumdiffusionsratenkontrollschicht 0,1 bis 100 nm beträgt, und
    wobei die Lithiumdiffusionsratenkontrollschicht ein oder zwei oder mehr Vertreter, ausgewählt aus der Gruppe bestehend aus $Al_2O_3$, $TiO_2$, $ZrO_2$, $HfO_2$, $Ta_2O_5$, $Nb_2O_5$, $Y_2O_3$, $CeO_2$, $SiO_2$, $La_2O_3$, $Ln_2O_3$, $Lu_2O_3$, $PrAlO_3$, $Er_2O_3$, HfA10, HfSiO, ZrSiO, ZrA10, HfON, HfSiON, $SrTiO_3$, $BaTiO_3$ und BST, einschließt.

**9.** Verfahren zur Herstellung einer Lithiumsekundärbatterie, wobei das Verfahren folgendes umfasst:

einen Schritt, in dem eine Negativelektrodenmischungsschicht auf einem Stromabnehmer ausgebildet wird (S21);

einen Schritt, in dem eine Lithiumdiffusionsratenkontrollschicht ausgebildet wird durch Wiederholen eines Atomlagenabscheidungsverfahrens zum Einbringen eines Metalloxids in die Negativelektrodenmischungsschicht (S22);

einen Schritt, in dem eine negative Elektrode hergestellt wird durch Laminieren eines Lithiumdünnfilms auf die Lithiumdiffusionsratenkontrollschicht (S23);

einen Schritt, in dem eine Elektrodenanordnung, die die in dem Schritt S23 hergestellte negative Elektrode einschließt, hergestellt wird (S24); und

einen Schritt, in dem ein Elektrolyt in die Elektrodenanordnung injiziert wird (S25),

wobei das Atomlagenabscheidungsverfahren durchgeführt wird bis die Dicke der Lithiumdiffusionsratenkontrollschicht 0,1 bis 100 nm beträgt, und

wobei die Lithiumdiffusionsratenkontrollschicht ein oder zwei oder mehr Vertreter, ausgewählt aus der Gruppe bestehend aus $Al_2O_3$, $TiO_2$, $ZrO_2$, $HfO_2$, $Ta_2O_5$, $Nb_2O_5$, $Y_2O_3$, $CeO_2$, $SiO_2$, $La_2O_3$, $Ln_2O_3$, $Lu_2O_3$, $PrAlO_3$, $Er_2O_3$, HfA10, HfSiO, ZrSiO, ZrA10, HfON, HfSiON, $SrTiO_3$, $BaTiO_3$ und BST, einschließt.

**10.** Verfahren nach mindestens einem der Ansprüche 8 und 9, wobei das Atomlagenabscheidungsverfahren durchgeführt wird bis die Dicke der Lithiumdiffusionsratenkontrollschicht 0,5 bis 50 nm beträgt.

**11.** Verfahren nach Anspruch 8, bei dem der Schritt S13 folgendes umfasst:

einen Schritt, in dem ein Produkt des Schritts S12 in einer Kammer positioniert wird;

einen Schritt, in dem Metallatome in die Kammer eingeleitet werden;

einen Schritt, in dem ein Spülgas in die Kammer eingeleitet wird;

einen Schritt, in dem ein Oxidationsmittel in die Kammer eingeleitet wird und so eine Metalloxidschicht gebildet wird; und

einen Schritt, in dem das Spülgas in die Kammer eingeleitet wird und so nicht umgesetztes Oxidationsmittel entfernt wird.

**12.** Verfahren nach Anspruch 9, bei dem der Schritt S22 folgendes umfasst:

einen Schritt, in dem ein Produkt des Schritts S21 in einer Kammer positioniert wird;

einen Schritt, in dem Metallatome in die Kammer eingeleitet werden;

einen Schritt, in dem ein Spülgas in die Kammer eingeleitet wird;

einen Schritt, in dem ein Oxidationsmittel in die Kammer eingeleitet wird und so eine Metalloxidschicht gebildet wird; und

einen Schritt, in dem das Spülgas in die Kammer eingeleitet wird und so nicht umgesetztes Oxidationsmittel entfernt wird.

**Revendications**

**1.** Électrode négative pour une batterie rechargeable au lithium, comprenant :

un collecteur de courant ;

une couche de mélange d'électrode négative formée sur le collecteur de courant ;

une couche de régulation de la vitesse de diffusion du lithium formée sur la couche de mélange d'électrode négative par dépôt en couche atomique ; et

une couche de lithium formée sur la couche de régulation de la vitesse de diffusion du lithium,

dans laquelle la couche de régulation de la vitesse de diffusion du lithium comprend un ou deux éléments ou davantage choisis dans le groupe constitué par l'$Al_2O_3$, le $TiO_2$, le $ZrO_2$, l'$HfO_2$, le $Ta_2O_5$, le $Nb_2O_5$, l'$Y_2O_3$, le $CeO_2$, le $SiO_2$, le $La_2O_3$, le $Ln_2O_3$, le $Lu_2O_3$, le $PrAlO_3$, l'$Er_2O_3$, l'HfAlO, l'HfSiO, le ZrSiO, le ZrA10,l'HfON, l'HfSiON, le $SrTiO_3$, le $BaTiO_3$ et le BST, et

dans laquelle une épaisseur de la couche de régulation de la vitesse de diffusion du lithium varie de 0,1 à 100 nm.

**2.** Électrode négative selon la revendication 1, dans laquelle la couche de régulation de la vitesse de diffusion du lithium régule, jusqu'à l'injection d'un électrolyte, la diffusion du lithium à partir de la couche de lithium et jusqu'à la couche de mélange d'électrode négative.

3. Électrode négative selon la revendication 1, dans laquelle la couche de régulation de la vitesse de diffusion du lithium régule, jusqu'à une première charge/décharge, la diffusion du lithium à partir de la couche de lithium et jusqu'à la couche de mélange d'électrode négative.

4. Électrode négative selon la revendication 1, dans laquelle une épaisseur de la couche de régulation de la vitesse de diffusion du lithium varie de 0,5 à 50 nm.

5. Électrode négative selon la revendication 1, dans laquelle la couche de mélange d'électrode négative comprend un composé ou un mélange d'au moins deux composés choisis dans le groupe constitué par le SiOx ($0 < x \leq 2$), le SnO et le $SnO_2$.

6. Électrode négative selon la revendication 1, dans laquelle la couche de régulation de la vitesse de diffusion du lithium est formée d'$Al_2O_3$.

7. Électrode négative selon la revendication 1, dans laquelle un rapport d'épaisseur entre la couche de régulation de la vitesse de diffusion du lithium et la couche de lithium varie de 1/100 à 1/20 000.

8. Procédé de fabrication d'une batterie rechargeable au lithium, le procédé comprenant :

   une étape de formation d'une couche de mélange d'électrode négative sur un collecteur de courant (S11);
   une étape de formation d'une couche mince de lithium sur une surface d'une plaque antiadhésive (S12) ;
   une étape de formation d'une couche de régulation de la vitesse de diffusion du lithium par répétition d'un processus de dépôt en couche atomique consistant à introduire un oxyde métallique sur la couche mince de lithium (S13) ;
   une étape de préparation d'une électrode négative par superposition de produits de l'étape S11 et de l'étape S13 de façon à ce que la couche de mélange d'électrode négative et la couche de régulation de la vitesse de diffusion du lithium puissent se faire face (S14) ;
   une étape de fabrication d'un ensemble électrode comprenant l'électrode négative préparée à l'étape S14 (S15) ; et
   une étape d'injection d'un électrolyte dans l'ensemble électrode (S16),
   dans lequel le processus de dépôt en couche atomique est mis en œuvre jusqu'à ce que l'épaisseur de la couche de régulation de la vitesse de diffusion du lithium devienne égale à 0,1 à 100 nm, et
   dans lequel la couche de régulation de la vitesse de diffusion du lithium comprend un ou deux éléments ou davantage choisis dans le groupe constitué par l'$Al_2O_3$, le $TiO_2$, le $ZrO_2$, l'$HfO_2$, le $Ta_2O_5$, le $Nb_2O_5$, l'$Y_2O_3$, le $CeO_2$, le $SiO_2$, le $La_2O_3$, le $Ln_2O_3$, le $Lu_2O_3$, le $PrAlO_3$, l'$Er_2O_3$, l'HfAlO, l'HfSiO, le ZrSiO, le ZrA10, l'HfON, l'HfSiON, le $SrTiO_3$, le $BaTiO_3$ et le BST.

9. Procédé de fabrication d'une batterie rechargeable au lithium, le procédé comprenant:

   une étape de formation d'une couche de mélange d'électrode négative sur un collecteur de courant (S21) ;
   une étape de formation d'une couche de régulation de la vitesse de diffusion du lithium par répétition d'un processus de dépôt en couche atomique consistant à introduire un oxyde métallique sur la couche de mélange d'électrode négative (S22) ;
   une étape de fabrication d'une électrode négative par superposition d'une couche mince de lithium sur la couche de régulation de la vitesse de diffusion du lithium (S23) ;
   une étape de fabrication d'un ensemble électrode comprenant l'électrode négative préparée à l'étape S23 (S24) ; et
   une étape d'injection d'un électrolyte dans l'ensemble électrode (S25),
   dans lequel le processus de dépôt en couche atomique est mis en œuvre jusqu'à ce que l'épaisseur de la couche de régulation de la vitesse de diffusion du lithium devienne égale à 0,1 à 100 nm, et
   dans laquelle la couche de régulation de la vitesse de diffusion du lithium comprend un ou deux éléments ou davantage choisis dans le groupe constitué par l'$Al_2O_3$, le $TiO_2$, le $ZrO_2$, l'$HfO_2$, le $Ta_2O_5$, le $Nb_2O_5$, l'$Y_2O_3$, le $CeO_2$, le $SiO_2$, le $La_2O_3$, le $Ln_2O_3$, le $Lu_2O_3$, le $PrAlO_3$, l'$Er_2O_3$, l'HfAlO, l'HfSiO, le ZrSiO, le ZrA10, l'HfON, l'HfSiON, le $SrTiO_3$, le $BaTiO_3$ et le BST.

**10.** Procédé selon l'une quelconque des revendications 8 et 9, dans lequel le processus de dépôt en couche atomique est mis en œuvre jusqu'à ce que l'épaisseur de la couche de régulation de la vitesse de diffusion du lithium devienne égale à 0,5 à 50 nm.

**11.** Procédé selon la revendication 8, dans lequel l'étape S13 comprend :

une étape de mise en place d'un produit de l'étape S12 dans une chambre ;
une étape d'apport d'atomes métalliques dans la chambre ;
une étape d'apport d'un gaz de purge dans la chambre ;
une étape d'apport d'un oxydant dans la chambre pour former une couche d'oxyde métallique ; et
une étape d'apport du gaz de purge dans la chambre pour éliminer un oxydant n'ayant pas réagi.

**12.** Procédé selon la revendication 9, dans lequel l'étape S22 comprend :

une étape de mise en place d'un produit de l'étape 21 dans une chambre ;
une étape d'apport d'atomes métalliques dans la chambre ;
une étape d'apport d'un gaz de purge dans la chambre ;
une étape d'apport d'un oxydant dans la chambre pour former une couche d'oxyde métallique ; et
une étape d'apport du gaz de purge dans la chambre pour éliminer un oxydant n'ayant pas réagi.

【Fig. 1】

【Fig. 2】

【Fig. 3】

【Fig. 4】

【Fig. 5】

【Fig. 6】

1

30a

20(20')

10(10')

【Fig. 7】

1

40

30a

20(20')

10(10')

【Fig. 8】

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- KR 1020180132011
- KR 1020180057513

- JP H10208776 B